Europäisches Patentamt

European Patent Office

Office européen des brevets

(11) Publication number: **0 066 175**
**B1**

# (12) EUROPEAN PATENT SPECIFICATION

(45) Date of publication of patent specification: **04.09.85**

(51) Int. Cl.⁴: **H 01 J 37/317, H 01 J 37/147**

(21) Application number: **82104325.4**

(22) Date of filing: **17.05.82**

(54) Ion implanter.

(30) Priority: **18.05.81 JP 70507/81**

(43) Date of publication of application:
**08.12.82 Bulletin 82/49**

(45) Publication of the grant of the patent:
**04.09.85 Bulletin 85/36**

(84) Designated Contracting States:
**DE FR GB NL**

(56) References cited:
**FR-A-2 133 315**
**GB-A-2 052 146**

**WESCON TECHNICAL PAPERS, vol.15, 1971, Hollywood (US) J.N.CECIL et al.: " Particle accelerators for ion implantation " pages 1-6.**

**JOURNAL OF VACUUM SCIENCE AND TECHNOLOGY, vol.13, no.5, September-October 1976, New York (US) G.RYDING et al.: "Features of high-current implanter and medium-current implanter" pages 1030-1036.**

**IBM TECHNICAL DISCLOSURE BULLETIN, vol.19, no.9, February 1977, New York (US) J.R.WINNARD: " Ion-beam scanning by magnetic means", pages 3411-3412.**

(73) Proprietor: **Hitachi, Ltd.**
**5-1, Marunouchi 1-chome**
**Chiyoda-ku Tokyo 100 (JP)**

(72) Inventor: **Tokiguchi, Katsumi**
**1-47-1-D304, Akatsuki-cho**
**Hachioji-shi Tokyo (JP)**
Inventor: **Sakudo, Noriyuki**
**4-587-16, Tomoda-cho**
**Ohme-shi Tokyo (JP)**
Inventor: **Koike, Hidemi**
**5-1-4-303, Nakaarai Tokorozawa-shi**
**Saitama-ken (JP)**

(74) Representative: **Strehl, Peter, Dipl.-Ing. et al**
**Strehl, Schübel-Hopf, Schulz Patentanwälte**
**Widenmayerstrasse 17 Postfach 22 03 45**
**D-8000 München 22 (DE)**

Courier Press, Leamington Spa, England.

**Description**

Background of the Invention

The present invention relates to an ion implanter for implanting ions of a predetermined sort into a sample such as semiconductor wafer.

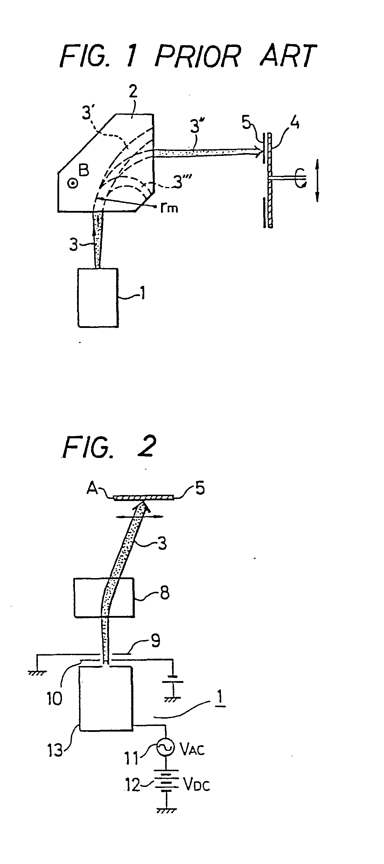

In ion implanters, it has heretofore been common practice that various ion beams extracted from an ion source are once separated according to masses by means of a magnetic separator so as to select only a specified sort of ions, whereupon the selected ions are implanted into a semiconductor wafer. Figure 1 shows the fundamental setup of a prior-art ion implanter. Referring to the figure, an ion beam 3 emergent from an ion source 1 is separated into ion beams 3', 3", 3''' etc. of individual ion sorts by a static magnetic field B which a magnetic mass separator 2 establishes. A semiconductor wafer 5 is mounted on the surface of a sample holder 4. The holder is mounted on the surface of a rotating disk. Owing to a combination of the rotational motion and a radial motion of the disk, the semiconductor wafer 5 is uniformly irradiated with the ion beam 3" consisting only of predetermined ions. In this case, the mass resolution of the magnetic mass separator 2 is proportional to the beam radius $r_m$ in the magnetic sector. In order to improve the mass resolution, the radius $r_m$ has to be increased. Therefore, the magnetic mass separator 2 and the whole ion implanter becomes large in size. Moreover, the transmissivity of the mass separator 2 for the ion beam is usually several tens %, and the beam loss is inevitable. Accordingly, the effective utilization factor of the ion implanting current compared to the ion beam 3 extracted from the ion source 1 is ordinarily 30% or so.

GB—A—20 52 146 discloses an ion implantation apparatus which comprises a mass analyzer and a magnetic type beam deflector. The beam reflector is disposed between the mass analyzer and the target and is used to laterally deflect the particle beam emanting from the mass analyzer. The beam deflector comprises an A.C.-driven electromagnet in order to prevent lateral velocity components of the ions emerging therefrom. While such an ion implantation apparatus is useful to avoid the disadvantages resulting from lateral velocity components and the corresponding variable angle of incidence of the ions, it still has a drawback of low transmissivity.

In recent years, an ion implant equipment which changes the surface property of a sample by implanting ions into the surface has been applied to various fields. In this case, the purity of the ion beam is not so important, and it is only required to perform the ion implantation into a large surface of the sample at high speed by increasing the ion implant current. Hitherto, there has not been an ion implanter which can satisfy such requirement.

Summary of the Invention

It is accordingly an object of the present invention to provide an ion implanter which realizes ion implantation at higher current level.

In order to accomplish the object, according to the present invention, an ion implanter is constructed of an ion source, a sample holder for supporting a sample to be implanted with ions, and scanning means for scanning an ion beam extracted from said ion source, the sample being located at a position where it avoids irradiation with neutral particles which propagate rectilinearly from said ion source.

The scanning means is constructed of a permanent magnet which is disposed between said ion source and the sample, and an A.C. power supply which is connected to said ion source in order to impose small fluctuations in the ion acceleration energy.

Owing to such characterizing features of the present invention, it has become possible to implant ions into a sample with a high current ion beam. As a result, an ion implanter capable of high-speed ion implantation has been provided.

Brief Description of the Drawings

Figure 1 is a view showing the fundamental setup of a prior-art ion implanter,

Figure 2 is a view showing the fundamental setup of an ion implanter according to the present invention.

Description of the Preferred Embodiments

Figure 2 shows the fundamental setup of an ion implanter according to the present invention. A semiconductor wafer 5 placed on a sample holder (not shown) is located in the direction in which an ion beam 3 from an ion source 1 propagates rectilinearly.

In this embodiment, a static magnetic field is imposed by using a peranent magnet 8. The ion beam 3 is deflected in the static magnetic field generated by the permanent magnet 8, depending upon the voltage of a D.C. power supply ($V_{DC}$) 12 for extracting the ion beam 3 from the ion source 1. At this time, the setup is so arranged that the ion beam 3 impinges upon the center of the semiconductor wafer 5. Of course, one end part A of the semiconductor wafer 5 has its position shifted sideways so as not to be irradiated with neutral particles which propagate rectilinearly from the ion source 1. Thus fast neutral particles emergent from the ion source 1 are prevented from becoming implanted into the semiconductor wafer 5. Neutral particle implantation results in dose non-uniformity over the semiconductor wafer 5. Subsequently, an A.C. voltage from the A.C. power supply ($V_{AC}$) 11 is superposed on the D.C. voltage from the D.C. power supply ($V_{DC}$) 12, whereby the ion beam 3 is laterally oscillated on the semiconductor wafer 5 as indicated by arrows.

On the other hand, the semiconductor wafer 5 is mechanically moved perpendicularly to the sheet of the drawing. Thus, the semiconductor wafer 5 is uniformly irradiated with the ion beam 3. Since the extraction voltage of the ion beam 3 fluctuates due to the application of the A.C. voltage, the extraction characteristics of the ion beam 3 change. In the experiment, however, the A.C. voltage $V_{AC}$ was approximately 1 — 2kV, when the D.C. acceleration voltage $V_{DC}$ was 30kV. The voltage fluctuation to this degree scarcely changes the extraction characteristics (beam current and shape). In the figure, numeral 13 designates a plasma chamber, numeral 10 a negative electrode and numeral 9 a ground electrode, and these constitute the ion source 1. In this embodiment, the ion beam 3 is scanned with the center on the semiconductor wafer 5. In the embodiment shown in Fig. 2, the amplitude of the oscillations can be made small, and the utilization factor of the beam current is improved.

According to the present invention, unlike the prior-art ion implanter shown in Figure 1, the mass separator 2 is not included, and the distance between the ion source 1 and the semiconductor wafer 5 is shortened. Therefore, loss of the ion beam 3 becomes extremely low, and the ion beam 3 extracted from the ion source 1 can be effectively utilized as it is.

In the ion implanter according to the present invention, mass separation is not performed. In this regard, there may be employed an ion source arrangement in which a solid material corresponding to the sort of implant ions is heated and vaporized and then introduced into the ion source 1, and the vapor is used as a working gas for the ion source 1, whereby the purity of the ion beam to be extracted is enhanced. As the ion source arrangement, it is possible to use, for example, a coaxial microwave ion source as disclosed in Japanese Patent Application No. 55—152140.

As a result, a P$^+$ implant current of 50—100 mA being several times greater than in the prior art was obtained at the position of the semiconductor wafer 5. By shifting one end A of the semiconductor wafer 5 so as to prevent the mixing of neutral particles, the dose uniformity within the 4″ Si Wafer could be suppressed to the order of several % with the standard deviation (1 σ ). This is equivalent to the uniformity in the prior art ion implanter. In addition, since the ion implant current increased, the ion implant time shortened and higher wafer throughput was realized. Further, when the junction characteristics of the wafer subjected to the ion implantation were investigated, an I (current) —V (voltage) curve equivalent to that attained by the prior art ion implanter was obtained, and no problem was involved in the performance of a semiconductor device.

As set forth above, according to the present invention, ion implantation with a high current ion beam is realized without degrading the uniformity of the ion implantation, and the effect is remarkable in practical use.

## Claims

1. An ion implanter comprising an ion source (1), a sample holder for supporting a sample (5) to be implanted with ions, and scanning means (6, 7; 8) for scanning an ion beam (3) extracted from said ion source, the sample being placed in a position where its irradiation with neutral particles propagating rectilinearly from said ion source is avoided, characterized in that said scanning means is constructed of a permanent magnet (8) which is disposed between said ion source (1) and the sample (5), and an A.C. power (11) supply which is connected to said ion source in order to impose small fluctuations in the acceleration energy of the ion beam.

2. An ion implanter according to claim 1, characterized in that said ion source (1) is a microwave ion source.

3. An ion implanter according to claim 1 or 2, characterized in that said sample holder is moved orthogonally to the scanning direction of the ion beam (3).

4. A method for ion-implanting a semiconductor wafer characterized by the use of an ion implanter according to any of the preceding claims.

## Patentansprüche

1. Ionen-Implantationsvorrichtung mit einer Ionenquelle (1), einem Probenhalter zum Halten einer Probe (5), in die Ionen implantiert werden sollen, und mit einer Abtasteinrichtung (6, 7; 8) zum Abrastern eines Ionen-Strahles (3), der aus der Ionenquelle ausgebildet wird, wobei die Probe in einer Stellung gehalten wird, in der ihre Bestrahlung mit sich rechtwinklig von der Ionenquelle fortbewegenden Neutralteilchen vermieden wird, dadurch gekennzeichnet, daß die Abtasteinrichtung aus einem Permanentmagneten (8), der zwischen der Ionenquelle (1) und der Probe (5) angeordnet ist, und einer Wechselspannungsquelle (11) besteht, die mit der Ionenquelle verbunden ist, um der Beschleunigungsenergie des Ionen-Strahles kleine Schwankungen zu überlagern.

2. Ionen-Implantationsvorrichtung nach Anspruch 1, dadurch gekennzeichnet, daß die Ionenquelle (1) eine Mikrowellen-Ionenquelle ist.

3. Ionen-Implantationsvorrichtung nach Anspruch 1 oder 2, dadurch gekennzeichnet, daß der Probanhalter senkrecht zur Abtastrichtung des Ionen-Strahles (3) bewegt wird.

4. Verfahren zur Ionen-Implantation einer Halbleiterscheibe, gekennzeichnet durch die Verwendung einer Ionen-Implantationsvorrichtung nach einem der vorangehenden Ansprüche.

## Revendications

1. Dispositif d'implantation d'ions comportant une source d'ions (1), un porte-échantillon servant à supporter un échantillon (5) dans lequel on doit effectuer une implantation d'ions, et un dispositif d'exploration par balayage (6, 7, 8) servant à réaliser un déplacement par balayage d'un faisceau d'ions (3) extrait de ladite source d'ions, l'échantillon étant placé dans une position où son irradiation par des particules neutres se propageant selon un déplacement rectiligne à partir de ladite source d'ions est évitée, caractérisé en ce que lesdits moyens d'exploration par balayage sont constitués par un aimant permanent (8) qui est disposée entre ladite source d'ions (1) et l'échantillon (5), et par une source d'alimentation en énergie à courant alternatif (11) qui est raccordée à ladite source d'ions de manière à imposer de petites fluctuations dans l'énergie d'accélération du faisceau d'ions.

2. Dispositif d'implantation d'ions selon la revendication 1, caractérisé en ce que ladite source d'ions (1) est une source d'ions à micro-ondes.

3. Dispositif d'implantation d'ions selon la revendication 2, caractérisé en ce que ledit porte-échantillon est déplacé perpendiculairement à la direction de balayage du faisceau d'ions (3).

4. Procédé pour réaliser l'implantation d'ions dans une pastille semiconductrice, caractérisé par l'utilisation d'un dispositif d'implantation d'ions conformément à l'une quelconque des revendications précédentes.

## FIG. 1 PRIOR ART

## FIG. 2

1